Europäisches Patentamt

European Patent Office

Office européen des brevets

(19)

(11) Veröffentlichungsnummer: **0 333 038**
**A1**

## (12) EUROPÄISCHE PATENTANMELDUNG

(21) Anmeldenummer: 89104201.2

(22) Anmeldetag: 09.03.89

(51) Int. Cl.⁴: **H01L 39/14 , H01L 39/24 , H01B 12/12**

(30) Priorität: 14.03.88 DE 3808474

(43) Veröffentlichungstag der Anmeldung:
20.09.89 Patentblatt 89/38

(84) Benannte Vertragsstaaten:
AT CH DE FR GB IT LI NL SE

(71) Anmelder: Siemens Aktiengesellschaft
Wittelsbacherplatz 2
D-8000 München 2(DE)

(72) Erfinder: Assmann, Helmut, Dr.
Schwabachstrasse 13
D-8524 Dormitz(DE)

(54) Verfahren und Einrichtung zur Herstellung einer supraleitenden Verbindungsleitung.

(57) Die Erfindung betrifft ein Verfahren und eine Einrichtung zur Herstellung einer supraleitenden Verbindungsleitung. Es ist vorgesehen, daß zunächst eine Leitung (1,8,11) verlegt wird, bei der zumindest eine äußere Schicht (2) aus einer ein supraleitendes Oxid bildenden Metallegierung besteht. Dann wird die bereits verlegte Leitung (1,8,11) aufgeheizt auf eine Temperatur, die unter der Schmelztemperatur der Metallegierung liegt. Gleichzeitig wird ein sauerstoffhaltiges Gas mit der Schicht (2) in Kontakt gebracht. Durch Erwärmung und Sauerstoffzufuhr bildet sich eine Oxidschicht (6,9,12), die bei entsprechender Kühlung supraleitend ist. Eine Einrichtung zur Durchführung des Verfahrens sieht eine mit einer geeigneten Metallegierung beschichtete Leitung (1,8,11) vor. Die Metallegierungsschicht (2) begrenzt einen Hohlraum, durch den ein sauerstoffhaltiges Gas zu leiten ist. Die beschichtete Leitung (1,8,11) ist heizbar. Zur Kühlung der fertigen Verbindungsleitung mit Kühlmedium, z.B. flüssigem Stickstoff dient entweder der bei der Herstellung von sauerstoffhaltigem Gas durchströmte Raum oder ein eigens dafür installiertes Rohr (11).

FIG 1

## Verfahren und Einrichtung zur Herstellung einer supraleitenden Verbindungsleitung

Die Erfindung betrifft ein Verfahren zur Herstellung einer supraleitenden Verbindungsleitung.

Es sind oxidische Supraleiter bekannt, deren Sprungtemperatur so hoch liegt, daß eine Kühlung mit flüssigem Stickstoff ausreicht, um Supraleitung zu gewährleisten. Diese Oxide werden bisher im allgemeinen auf pulvermetallurgischem Wege hergestellt. Diese Oxide sind sehr spröde und somit nur sehr schwer formbar. Eine Herstellung von Verbindungsleitungen, die für die öffentliche Elektrizitätsversorgung nutzbar sein sollen, allein aus den bekannten Oxiden ist daher nicht durchführbar. Eine Unterlage, beispielsweise aus Metall, mit aufgebrachter Oxidschicht eignet sich besser zum Aufbau einer Verbindungsleitung. Das Oxid ist aber mit üblichen Verfahren nur weitgehend spannungsfrei auf die Unterlage aufzubringen. Durch unterschiedliche Wärmedehnungen können daher Risse in der Oxidschicht entstehen, die eine durchgehende Supraleitung behindern oder sogar unterbrechen.

Das Aufbringen eines fertigen Oxides auf einen Träger ist folglich nicht anwendbar, falls die auf diese Weise hergestellten Verbindungsleitung später nicht überall zugänglich ist. Das ist aber der Fall, falls die Verbindungsleitung über große Entfernungen verlegt ist. Hinzu kommt, daß auch eine unterirdische Verlegung infrage kommen soll.

Es ist also notwendig, ein Verfahren zur Herstellung einer supraleitenden Verbindungsleitung zu entwickeln. wobei ein Haften der Oxidschicht auf der Unterlage unter Druckspannung gewährleistet ist.

Ein Verfahren zur Herstellung eines keramischen Supraleitermaterials mit hoher Sprungtemperatur ist bereits in der deutschen Patentanmeldung P 37 11 975.3 beschrieben worden. Dabei wird zunächst eine Vorlegierung hergestellt, die dann einer Oxidationsbehandlung bei gleichzeitiger Wärmebehandlung zur Ausbildung der gewünschten supraleitenden Metalloxidphase unterzogen wird. Dabei werden stets Temperaturverhältnisse eingehalten, bei denen ein Aufschmelzen des Materials ausgeschlossen ist. Mit diesem Verfahren erhält man ein keramisches Supraleitermaterial, das sehr feinkörnig ist. Außerdem ist eine homogene Verteilung der Metallatome der Legierung im mikroskopischen Bereich gewährleistet, was eine schnelle Bildung der supraleitenden Oxide ermöglicht.

Der Erfindung lag die Aufgabe zugrunde, ein Verfahren zur Herstellung einer supraleitenden Verbindungsleitung, die für die öffentliche Elektrizitätsversorgung einsetzbar ist, zu entwickeln. Dabei soll einer sehr gute Haftung der Oxidschicht auf einem Träger gewährleistet sein, damit Unterbrechungen der Supraleitung auf ein Minimum beschränkt werden. Insbesondere soll das Verfahren aus einsetzbar sein, um eine bereits verlegte Verbindungsleitung nach einem Defekt in einfacher Weise instandzusetzen.

Die Aufgabe wird erfindungsgemäß dadurch gelöst,
daß zunächst eine Leitung, bei der zumindest eine äußere Schicht aus einer ein supraleitendes Oxid bildenden kristallinen oder amorphen Metallegierung besteht, verlegt wird, und daß dann die bereits verlegte Leitung aufgeheizt wird auf eine Temperatur, die unter der Schmelztemperatur der Metallegierung liegt und daß gleichzeitig ein sauerstoffhaltiges Gas mit der zugänglichen Oberfläche der ein supraleitendes Oxid bildenden Metallegierung in Kontakt gebracht wird, wodurch sich eine bei Abkühlung supraleitende Oxidschicht bildet.

Eine geeignete Metallegierung hat beispielsweise die Zusammensetzung $Ma_1 Mb_2 Cu_3$ oder ist eine Ma-Mb-Niob-Kupfer-Legierung. Ma ist dabei ein seltenes Erdmetall, insbesondere Yttrium, Lanthan oder ein Lanthanid. Mb ist ein Erdalkalimetall, insbesondere Barium oder Strontium.

Geeignete Metallegierungen sind beispielsweise auch Wismut-Strontium-Calcium-Kupfer-Legierungen, oder Wismut-Blei-Strontium-Calcium-Kupfer-Legierungen oder Wismut-Blei-Antimon-Strontium-Calcium-Kupfer-Legierungen oder Thallium-Calcium-Barium-Kupfer-Legierungen. Insbesondere sind geeignet $Bi_2 Sr_3 Ca_3 Cu_2$ oder $Bi_2 Sr_2 Ca_2 Cu$ oder $Bi_2 Sr_2 CaCu_2$ oder $Bi_2 Sr_2 Ca_2 Cu_3$ oder $Bi_{1,7} Pb_{0,3} Sr_2 Ca_2 Cu_{3,6}$ oder $Bi_{1,6} Pb_{0,3} Sb_{0,1} Sr_2 Ca_2 Cu_3$ oder $Tl_2 Ca_{n-1} Ba_2 Cu_n$ oder $TlCa_{n-1} Ba_2 Cu_n$, wobei $n = 2, 3, 4$ oder 5, oder $TlCa_2 Ba_3 Cu_4$.

Erfindungsgemäß wird die Oxidbildung erst an der bereits verlegten Leitung vorgenommen. Damit wird der Vorteil erzielt, daß eine Beschädigung der Oxidschicht während der Verlegungsarbeiten der Leitung ausgeschlossen ist. Durch die erfindungsgemäße Oxidation im verlegten Rohr entsteht in der Oxidschicht eine Druckspannung, die eine besonders haltbare Haftung der Oxidschicht auf ihrer Unterlage sicherstellt. Diese Druckspannung ist darauf zurückzuführen, daß durch den Oxidationsvorgang die Dichte eines Stoffes abnimmt. Die Dichte des supraleitenden Oxides ist also geringer als die Dichte der das supraleitende Oxid bildende Metallegierung. Mit dem erfindungsgemäßen Verfahren wird durch eine Festkörperreaktion die Oxidfront gleichmäßig immer weiter in die Metallschicht hineingeschoben. Die Geschwindigkeit des Hereinwachsens hängt dabei von der Temperatur ab. Die Temperatur liegt aber stets unterhalb der Schmelztemperatur der Legierung.

Damit ein als solches bekanntes supraleitendes Oxid mit der richtigen Zusammensetzung, z.B. $YBa_2Cu_3O_{6,85}$ entsteht, ist abhängig von der gewählten Temperatur ein bestimmter Sauerstoffpartialdruck in der Oxidationsatmosphäre notwendig.

Mit dem erfindungsgemäßen Verfahren wird eine weitere Erhöhung der Druckspannung und damit der Haftung des Oxids auf seinem Träger durch das Abkühlen der fertigen Verbindungsleitung erzielt. Zur Herstellung ist die Leitung auf eine Temperatur unterhalb des Schmelzpunktes der Legierung aufgeheizt. Damit die fertige Verbindungsleitung supraleitend wird, ist eine Abkühlung auf die Arbeitstemperaur des betreffenden Supraleiters, die z.B. die Temperatur des flüssigen Stickstoffes sein kann, erforderlich. Durch diese Abkühlung entsteht eine zusätzliche Druckspannung in der Oxidschicht.

Eine mit dem erfindungsgemäßen Verfahren hergestellte Verbindungsleitung ist wegen der guten Haftung der Oxidschicht sogar unempfindlich gegen Verformungen. Damit wird der Vorteil erzielt, daß äußere Kräfte auf die verlegte Leitung, beispielsweise Bodenkräfte, die auf unterirdisch verlegte Leitungen einwirken, für den Bestand der Oxidschicht ohne Bedeutung sind.

Auf die Oxidschicht wirkt wegen der hohen Druckspannung ein sehr hoher Druck ein. Durch diesen mit dem erfindungsgemäßen Verfahren erst erzeugten hohen Druck wird gegenüber einem nichtdruckbelasteten gleichartigen Oxid sogar eine Erhöhung der Sprungtemperatur für Supraleitung erzielt.

Die mit dem erfindungsgemäßen Verfahren hergestellte Verbindungsleitung ist unempfindlich hinsichtlich mechanischer Beanspruchungen und zeichnet sich gegenüber dem Bekannten durch eine höhere Sprungtemperatur aus. Darüber hinaus wird mit dem erfindungsgemäßen Verfahren der Vorteil erzielt, daß stets eine homogene Oxidschicht entsteht, weil der Oxidationsvorgang an der bereits verlegten Leitung vorgenommen wird. Das erfindungsgemäße Verfahren eignet sich darüber hinaus dazu, Defekte an der Oxidschicht direkt in einer verlegten Leitung zu beheben. Dazu ist eine Lokalisierung des Defektes, die bei unterirdisch verlegten Leitungen nahezu unmöglich ist, nicht erforderlich. Wird die Verbindungsleitung nach Entfernen des Kühlmediums gemäß dem erfindungsgemäßen Verfahren aufgeheizt und mit oxidierendem Gas beschickt, dann werden Defekte in der Oxidschicht durch Bildung neuer Oxide beseitigt. Das erfindungsgemäße Verfahren eignet sich demnach besonders vorteilhaft auch zur Reparatur bereits verlegter supraleitender Verbindungsleitungen.

Zur Oxidation der Metallegierung wird die Verbindungsleitung beispielsweise auf eine Temperatur zwischen 400°C und 600°C erwärmt. Dann wird die zu oxidierende Oberfläche mit einem sauerstoffhaltigen Inertgas in Kontakt gebracht. Bei der genannten Temperatur eignet sich eine Mischung aus Inertgas und Sauerstoff mit einem Sauerstoffanteil von 1 %. Mit diesen beispielsweise einzusetzenden Parametern wird eine gut geeignete supraleitende Verbindung hergestellt.

Beispielsweise wird die Schicht aus einer ein supraleitendes Oxid bildenden Metallegierung auf eine Verbindungsleitung, die aus elektrisch leitendem Material besteht, aufgebracht. Damit wird der Vorteil erzielt, daß, falls im Betrieb der Verbindungsleitung die Supraleitung ausfällt, ein Stromfluß noch durch das nicht supraleitende elektrisch leitende Material gegeben ist. Ein Ausfall der Supraleitung würde schon dann eintreten, falls die Versorgung mit dem Kühlmedium unterbrochen wäre.

Zur Bildung der Oxidschicht wird die verlegte Verbindungsleitung beispielsweise elektrisch aufgeheizt. Dazu wird entweder ein elektrischer Heizstrom durch die Leitung selbst geführt oder es wird eine bereits installierte Heizwendel aktiviert. Nach einem anderen Beispiel ist die Leitung dadurch aufzuheizen, daß das zugeleitete sauerstoffhaltige Gas erwärmt ist.

Eine besonders große Festigkeit der Oxidschicht wird erzielt, falls die verlegte Verbindungsleitung nach der Oxidation sofort bis auf die Arbeitstemperatur des Supraleiters, die beispielsweise unter dem Siedepunkt von Stickstoff liegt, abgekühlt wird.

Eine Einrichtung zur Durchführung des erfindungsgemäßen Verfahrens sieht eine Verbindungsleitung vor, mit zumindest einer Oberfläche, die gebildet ist aus einer ein supraleitendes Oxid bildenden Metallegierung. Dieser Oberfläche ist eine Hohlleitung begrenzend angeordnet. Die Verbindungsleitung ist heizbar und die Hohlleitung ist mit einem sauerstoffhaltigen Gas zu beschicken. Die Leitung kann auch ganz aus einer ein supraleitendes Oxid bildenden Metallegierung bestehen oder kann mit einer solchen Legierung beschichtet sein. Wesentlich ist, daß mindestens ein in Längsrichtung der Leitung ununterbrochener Streifen aus einer solchen Legierung vorhanden ist.

Beispielsweise ist die Verbindungsleitung ein Rohr, dessen Innenoberfläche durch eine ein supraleitendes Oxid bildende Metallegierung gebildet ist. Das Rohr kann einen beliebigen Querschnitt haben. Beispielsweise ist auch ein Kastenprofil denkbar. Das Rohr ist zur Oxidbildung mit sauerstoffhaltigem Gas zu beschicken. Bei fertiggestellter Verbindungsleitung wird durch das Rohr das für die Aufrechterhaltung der Supraleitung notwendig Kühlmittel geleitet.

Nach einem anderen Beispiel ist eine Leitung, deren Oberfläche aus einer ein supraleitendes Oxid bildenden Metallegierung besteht, in einem sie umgebenden Rohr angeordnet. Das Rohr ist zur Bildung des Oxides mit einem sauerstoffhaltigen Gas zu beschicken un dient zur späteren Aufnahme von Kühlmittel.

Nach einem weiteren Beispiel weist die Verbindungsleitung ein erstes Rohr auf, dessen Außenoberfläche durch eine ein supraleitendes Oxid bildende Metallegierung gebildet ist. Das erste Rohr ist in einem es umgebenden zweiten Rohr angeordnet. Zur Herstellung der supraleitenden Verbindungsleitung ist der Raum zwischen dem ersten und dem zweiten Rohr mit sauerstoffhaltigem Gas zu beschicken. Im Betrieb ist diesem Raum trockene Luft zur Isolierung zuführbar. Das Kühlmittel fließt durch das erste Rohr.

Die zunächst zu verlegende Leitung besteht beispielsweise aus einem elektrisch leitenden Material, insbesondere aus Kupfer, und ist mit einer ein supraleitendes Oxid bildenden Metallegierung beschichtet. Durch die Verwendung von Kupfer oder einem anderen gut leitenden Material ist stets eine wenn auch nicht supraleitende elektrische Verbindung vorhanden, selbst dann, falls die supraleitende Oxidschicht unterbrochen sein sollte. Zum Aufbringen der Legierung sind als solche bekannte Beschichtungsverfahren anwendbar. Beispielsweise kann die Schicht aufgewalzt werden. Es ist auch möglich, daß die gesamte Verbindungsleitung aus einer ein supraleitendes Oxid bildenden Metallegierung besteht oder, daß nur ein längs der Leitung sich erstreckender Streifen mit einer solchen beschichtet ist.

Zum Aufheizen der Verbindungsleitung, um die Oxidbildung zu ermöglichen, ist die Verbindungsleitung beispielsweise mit einer Heizspirale versehen. Die Verbindungsleitung kann zum Aufheizen auch mit einer Spannungsquelle zu verbinden sein. Die Zuführung des sauerstoffhaltigen Gases erfolgt beispielsweise über einen Anschlußstutzen.

Um eine Reparatur einer bereits verlegten supraleitenden Verbindungsleitung mit dem erfindungsgemäßen Verfahren zu ermöglichen, ohne daß die Energieübertragung unterbrochen wird, sind für eine Energieübertragungstrasse mehrere parallel verlegte gleichartige Supraleiter einzusetzen. Durch diesen redundanten Aufbau ist es möglich, einen der Supraleiter zur Reparatur abzuschalten. Eine Reparatur ist nötig, falls die Oxidoberfläche beschädigt ist. Durch Erwärmung und Zufuhr eines oxidierenden Gases nach dem erfindungsgemäßen Verfahren wird aus der noch unbeschädigten Legierung, dort wo diese nicht durch Oxid bedeckt ist, eine neue Oxidschicht gebildet.

Mit dem erfindungsgemäßen Verfahren zur Herstellung einer supraleitenden Verbindungsleitung und mit der Einrichtung zur Durchführung dieses Verfahrens wird insbesondere der Vorteil erzielt, daß eine mechanisch stabile für die Energieübertragung über große Distanzen geeignete supraleitende Verbindungsleitung zur Verfügung steht, die darüber hinaus auf einfache Weise im verlegten Zustand ohne Ortung eines möglichen Defektes in der Oxidschicht zu reparieren ist.

Die Erfindung wird anhand der Zeichnung näher erläutert:

FIG 1 zeigt einen Längsschnitt durch eine erfindungsgemäße supraleitende Verbindungsleitung.

FIG 2 zeigt einen Querschnitt derselben Verbindungsleitung.

Die FIG 3 und 4 zeigen Varianten der supraleitenden Verbindungsleitung.

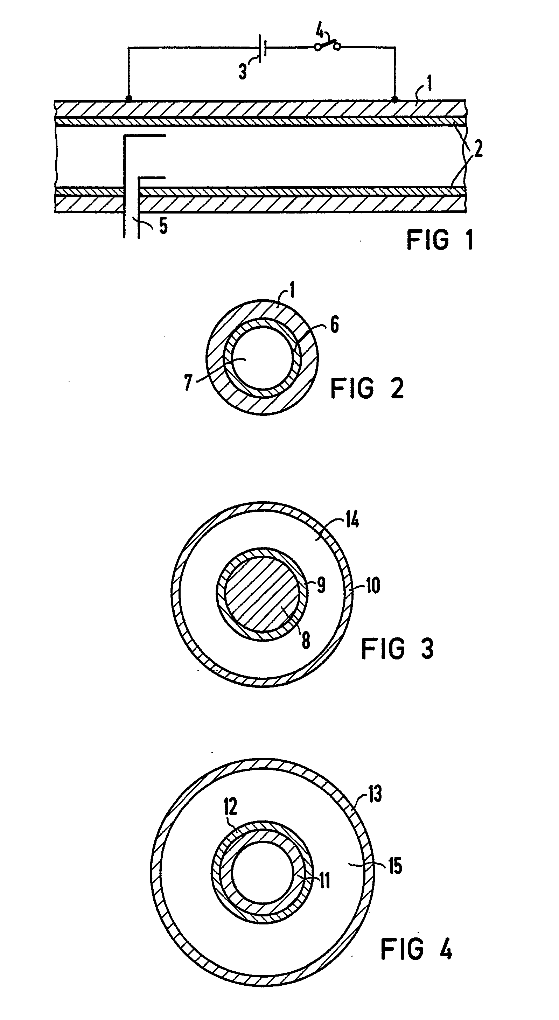

Die zunächst verlegte Leitung nach FIG 1 besteht aus einem Kupferrohr 1, dessen Innenoberfläche mit einer Schicht 2 versehen ist, die aus einer ein supraleitendes Oxid bildenden Metallegierung besteht. Das Kupferrohr 1 steht mit einer Spannungsquelle 3 in Verbindung, von der ausgehend durch Schließen eines Schalters 4 ein Heizstrom durch das Kupferrohr 1 zu leiten ist. Das Kupferrohr 1 ist außerdem mit einem Anschlußstutzen 5 für ein sauerstoffhaltiges Gas verbunden. Wird das Kupferrohr 1 erhitzt und wird gleichzeitig sauerstoffhaltiges Gas mit der Schicht 2 in Kontakt gebracht, dann bildet sich eine supraleitende Oxidschicht aus.

FIG 2 zeigt einen Querschnitt durch die fertige supraleitende Verbindungsleitung. Das Kupferrohr 1 weist innen eine supraleitende Oxidschicht 6 auf. Durch den lichten Querschnitt 7 der fertigen Leitung wird im Betrieb Kühlmittel, z.B. flüssiger Stickstoff geleitet.

Nach FIG 3 ist als Variante einer supraleitenden Verbindungsleitung statt eines Kupferrohres ein Kupferkabel 8 verlegt. Das Kupferkabel ist vollständig durch eine supraleitende Oxidschicht 9 bedeckt. Das beschichtete Kupferkabel 8 befindet sich im Inneren eines Rohres 10. Durch den Ringraum 14 zwischen dem Kabel 8 und dem Rohr 10 wird zu Bildung der Oxidschicht 9 sauerstoffhaltiges Gas und im Betrieb Kühlmittel geleitet.

Eine weitere supraleitende Verbindungsleitung nach FIG 4 besteht aus einem Kupferrohr 11, das außen mit einer supraleitenden Oxidschicht 12 versehen ist. Das Kupferrohr 11 ist in einem Rohr 13 angeordnet. Zur Bildung der Oxidschicht 12 wird durch den Ringraum 15 zwischen dem Kupferrohr 11 und dem Rohr 13 ein sauerstoffhaltiges Gas geleitet. Im Betrieb nimmt das Kupferrohr 11 Kühlmittel, z.B. flüssigen Stickstoff auf. Der Ringraum 15 zwischen dem Kupferrohr 11 und dem Rohr 13 ist dann zur Isolierung mit einem inerten, trockenen Gas angefüllt.

## Ansprüche

1. Verfahren zur Herstellung einer supraleitenden Verbindungsleitung, **dadurch gekennzeichnet,** daß zunächst eine Leitung (1,8,11), bei der zumindest eine äußere Schicht (2) aus einer ein supraleitendes Oxid bildenden kristallinen oder amorphen Metallegierung besteht, verlegt wird, und daß dann die bereits verlegte Leitung (1,8,11) aufgeheizt wird auf eine Temperatur, die unter der Schmelztemperatur der Metallegierung liegt und daß gleichzeitig ein sauerstoffhaltiges Gas mit der zugänglichen Oberfläche der ein supraleitendes Oxid bildenden Metallegierung in Kontakt gebracht wird, wodurch sich eine bei Abkühlung supraleitende Oxidschicht (6,9,12) bildet.

2. Verfahren nach Anspruch 1, **dadurch gekennzeichnet,** daß die äußere Schicht (2) aus einer ein supraleitendes Oxid bildenden Metallegierung mit der Zusammensetzung $Ma_1Mb_2Cu_3$ oder aus einer Ma-Mb-Niob-Kupfer-Legierung besteht, wobei Ma ein seltenes Erdmetall, insbesondere Yttrium, Lanthan oder ein Lanthanid ist und wobei Mb ein Erdalkalimetall, insbesondere Barium oder Strontium ist.

3. Verfahren nach Anspruch 1, **dadurch gekennzeichnet,** daß die äußere Schicht (2) aus einer Wismut-Strontium-Calcium-Kupfer-Legierungen, oder aus einer Wismut-Blei-Strontium-Calcium-Kupfer-Legierungen oder aus einer Wismut-Blei-Antimon-Strontium-Calcium-Kupfer-Legierungen oder aus einer Thallium-Calcium-Barium-Kupfer-Legierung, insbesondere aus $Bi_2Sr_3Ca_3Cu_2$ oder $Bi_2Sr_2Ca_2Cu$ oder $Bi_2Sr_2CaCu_2$ oder $Bi_2Sr_2Ca_2Cu_3$ oder $Bi_{1,7}Pb_{0,3}Sr_2Ca_2Cu_{3,6}$ oder $Bi_{1,6}Pb_{0,3}Sb_{0,1}Sr_2Ca_2Cu_3$ oder $Tl_2Ca_{n-1}Ba_2Cu_n$ oder $TlCa_{n-1}Ba_2Cu_n$, wobei n = 2, 3, 4 oder 5, oder $TlCa_2Ba_3Cu_4$ besteht, die ein supraleitendes Oxid bildende kristalline oder amorphe Metallegierungen sind.

4. Verfahren nach Anspruch 1, **dadurch gekennzeichnet,** daß die Leitung (1,8,11) zur Oxidation der ein supraleitendes Oxid bildenden Metallegierung auf 400°C bis 600°C erwärmt wird.

5. Verfahren nach Anspruch 1, **dadurch gekennzeichnet,** daß mit der Oberfläche der Leitung (1,8,11), die eine Schicht (2) aus einer ein supraleitendes Oxid bildenden Metallegierung aufweist, ein sauerstoffhaltiges Inertgas in Kontakt gebracht wird.

6. Verfahren nach Anspruch 5, **dadurch gekennzeichnet,** daß mit der Oberfläche der Leitung (1,8,11) eine Mischung aus einem Inertgas und Sauerstoff mit einem Sauerstoffanteil von 1 % in Kontakt gebracht wird.

7. Verfahren nach Anspruch 1, **dadurch gekennzeichnet,** daß die Schicht (2) aus einer ein supraleitendes Oxid bildenden Metallegierung auf eine Leitung (1,8,11) aus elektrisch leitendem Material aufgebracht wird.

8. Verfahren nach Anspruch 4, **dadurch gekennzeichnet,** daß zur Oxidation die bereits verlegte Leitung (1,8,11) elektrisch aufgeheizt wird.

9. Verfahren nach Anspruch 4, **dadurch gekennzeichnet,** daß zur Oxidation die bereits verlegte Leitung (1,8,11) durch ein vorbeiströmendes heißes sauerstoffhaltiges Gas aufgeheizt wird.

10. Verfahren nach Anspruch 1, **dadurch gekennzeichnet,** daß die bereits verlegte Leitung (1,8,11) nach der Oxidation bis zur Arbeitstemperatur des zu bildenden Supraleiters abgekühlt wird.

11. Verfahren nach Anspruch 10, **dadurch gekennzeichnet,** daß die bereits verlegte Leitung (1,8,11) nach der Oxidation bis unter den Siedepunkt von Stickstoff abgekühlt wird.

12. Einrichtung zur Durchführung des Verfahrens nach Anspruch 1, **dadurch gekennzeichnet,** daß eine Leitung (1,8,11) verlegt ist, mit zumindest einer Schicht (2), die gebildet ist aus einer ein supraleitendes Oxid bildenden Metallegierung, wobei diese Schicht (2) eine Hohlleitung (7,14,15) begrenzend angeordnet ist und daß die Leitung (1,8,11) heizbar und die Hohlleitung (7,14,15) mit einem sauerstoffhaltigen Gas zu beschicken ist.

13. Einrichtung nach Anspruch 12, **dadurch gekennzeichnet,** daß eine Leitung (8), deren Oberfläche aus einer ein supraleitendes Oxid bildenden Metallegierung besteht, in einem sie umgebenden Rohr (10) angeordnet ist, das mit einem sauerstoffhaltigen Gas zu beschicken ist und das zur späteren Aufnahme eines Kühlmediums zur Gewährleistung der Supraleitung dient.

14. Einrichtung nach Anspruch 12, **dadurch gekennzeichnet,** daß die Leitung ein Rohr (1) zur späteren Aufnahme des Kühlmediums ist, dessen Innenoberfläche aus einer ein supraleitendes Oxid bildende Metallegierung besteht, und das mit einem sauerstoffhaltigen Gas zu beschicken ist.

15. Einrichtung nach Anspruch 12, **dadurch gekennzeichnet,** daß die Leitung ein erstes Rohr (11) zur späteren Aufnahme des Kühlmediums aufweist, dessen Außenoberfläche aus einer ein supraleitendes Oxid bildende Metallegierung besteht und das in einem es umgebenden zweiten Rohr (13) angeordnet ist, welches mit einem sauerstoffhaltigen Gas zu beschicken ist.

16. Einrichtung nach Anspruch 12, **dadurch gekennzeichnet,** daß die Leitung (1,8,11) aus einer ein supraleitendes Oxid bildenden Metallegierung besteht.

17. Einrichtung nach Anspruch 12, **dadurch gekennzeichnet,** daß die Leitung (1,8,11) mit einer Schicht (2) aus einer ein supraleitendes Oxid bildenden Metallegierung versehen ist.

18. Einrichtung nach Anspruch 12, **dadurch gekennzeichnet,** daß die Leitung (1,8,11) aus einem elektrisch leitenden Material, insbesondere aus Kupfer, besteht und mit einer Schicht (2) aus einer ein supraleitendes Oxid bildenden Metallegierung versehen ist.

19. Einrichtung nach Anspruch 12, **dadurch gekennzeichnet,** daß die Leitung (1,8,11) zum Aufheizen mit einer Heizspirale versehen ist.

20. Einrichtung nach Anspruch 12, **dadurch gekennzeichnet,** daß die Leitung (1,8,11) zum Aufheizen mit einer Spannungsquelle (3) zu verbinden ist.

21. Einrichtung nach Anspruch 12, **dadurch gekennzeichnet,** daß die Hohlleitung (7,14,15) zur Zuführung eines sauerstoffhaltigen Gases mit einem Anschlußstutzen (5) verbunden ist.

P 3095

FIG 1

FIG 2

FIG 3

FIG 4

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | ADVANCED CERAMIC MATERIALS, Band 2, Nr. 3B, Juli 1987, Seiten 530-538, ACerS; C.K. CHIANG et al.: "Low temperature thermal processing of Ba2YCu3O7-x superconducting ceramics" * Seite 533: "Conclusion" * --- | 1,2,4 | H 01 L 39/14 H 01 L 39/24 H 01 B 12/12 |
| A | APPLIED PHYSICS A, Band 45, 1988, Seiten 261-263, Springer-Verlag; C. POLITIS; "High-Tc superconductivity in the multi phases Sr-Bi-Ca-Cu-O" * Insgesamt * --- | 2,3 | |
| A | GB-A-1 285 442 (CENTRAL ELECTRIC GENERAL BOARD) * Seite 3, Zeile 102 - Seite 4, Zeile 14; Figur 1 * --- | 13,15 | |
| P,A | APPL. PHYS. LETT. Band 52, Nr. 21, 23. Mai 1988, Seiten 1828-1830, American Institute of Physics; C.E. RICE et al.: "Preparation of superconducting thin films of calcium strontium bismuth copper oxides by coevaporation" * Seite 1829, linke Spalte * --- | 2,3 | RECHERCHIERTE SACHGEBIETE (Int. Cl.4) H 01 L |
| P,A | JOURNAL OF CRYSTAL GROWTH, Band 91, Nr. 3, 2. August 1988, Seiten 352-354, Elsevier Science Publishers B.V., Amsterdam, NL; H. ADACHI et al.: "Superconducting thin films of Bi-Sr-Ca-Cu-O and Tl-Ba-Ca-Cu-O with Tc above 100K" * Insgesamt * ----- | 2,3 | |

Der vorliegende Recherchenbericht wurde für alle Patentansprüche erstellt

| Recherchenort | Abschlußdatum der Recherche | Prüfer |
|---|---|---|
| DEN HAAG | 16-06-1989 | BAILLET B.J.R. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
......................................................................
& : Mitglied der gleichen Patentfamilie, übereinstimmendes Dokument